(19) Europäisches Patentamt / European Patent Office / Office européen des brevets

(11) **EP 4 002 039 B1**

(12) **EUROPÄISCHE PATENTSCHRIFT**

(45) Veröffentlichungstag und Bekanntmachung des Hinweises auf die Patenterteilung:
**11.06.2025 Patentblatt 2025/24**

(21) Anmeldenummer: **21193150.6**

(22) Anmeldetag: **26.08.2021**

(51) Internationale Patentklassifikation (IPC):
***G05B 23/02*** *(2006.01)*

(52) Gemeinsame Patentklassifikation (CPC):
**G05B 23/0283; G05B 23/0286**

(54) **VERFAHREN ZUR BESTIMMUNG EINES SCHÄDIGUNGSAUSMASSES**

METHOD FOR DETERMINING THE EXTENT OF DAMAGE

PROCÉDÉ DE DÉTERMINATION DE L'ÉTENDUE DE DOMMAGES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.11.2020 AT 510112020**

(43) Veröffentlichungstag der Anmeldung:
**25.05.2022 Patentblatt 2022/21**

(73) Patentinhaber: **Uptime Holding GmbH 8010 Graz (AT)**

(72) Erfinder: **Langmayr, Franz 8020 Graz (AT)**

(74) Vertreter: **Wirnsberger & Lerchbaum Patentanwälte OG Mühlgasse 3 8700 Leoben (AT)**

(56) Entgegenhaltungen:
**US-A1- 2011 137 575     US-A1- 2012 283 963
US-A1- 2014 379 199**

**Beschreibung**

Die Erfindung betrifft ein Verfahren zur Bestimmung eines Ausmaßes einer Schädigung einer Komponente eines mechatronischen Systems.

Aus dem Stand der Technik ist es bekannt, einen Zustand mechatronischer Systeme zu überwachen, indem eine Ist-Funktion des Systems überwacht wird, und bei einer Verschlechterung der Ist-Funktion, welche über eine vordefinierte bzw. zulässige Schwelle hinausgeht, eine Wartung durchzuführen, um die Ist-Funktion wieder gewährleisten zu können.

Beispielsweise kann eine Funktion eines Wälzlagers durch Vibrationsmessungen ermittelt und eine Wartung ausgelöst werden, wenn die Vibrationen einen vordefinierten Schwellwert überschreiten. Analog ist es aus dem Stand der Technik bekannt, dass ein Verschleiß an einem Ventilsitz einer Verbrennungskraftmaschine über eine Leckage zu einem höheren Kraftstoffverbrauch und Abweichungen bei einer Abgaszusammensetzung führt, sodass entsprechende Messwerte als Indiz für einen zunehmenden Verschleiß am Ventilsitz dienen und eine Wartung auslösen können.

Bei modernen, selbstlernenden Systemen ist ein derartiger Zusammenhang oftmals nicht mehr gegeben, zumal diese Systeme häufig Kompensationseinrichtungen aufweisen, mit welchen eine Funktion des Systems auch dann aufrechterhalten wird, wenn eine Komponente in einem Ausmaß geschädigt ist, welches geringer als ein Versagensschädigungsausmaß ist. Beispielsweise wird bei derartigen modernen Systemen ein Verschleiß an einem Ventilsitz oder einem Ventilteller, welcher grundsätzlich zu einer Leckage führen würde, durch Änderungen einer Ventilposition in einem geschlossenen Zustand des Ventils kompensiert, sodass das Ventil durch die Kompensationseinrichtung um einen dem Ausmaß des Verschleißes im Wesentlichen entsprechenden zusätzlichen Hub bewegt wird, um eine Auswirkung des Verschleißes auf die Funktion zu kompensieren.

Ein Verschleiß ist daher nicht mehr durch eine Leckage, einen erhöhten Kraftstoffverbrauch oder eine geänderte Abgaszusammensetzung erfassbar, solange die Schädigung geringer als das Versagensschädigungsausmaß ist. Bis zum Eintritt eines Versagens des Systems bzw. bis eine Schädigung der Komponente entsprechend dem Versagensschädigungsausmaß erreicht wird, ist somit gegenwärtig eine Schädigung der Komponente nicht bestimmbar und daher auch eine zustandsbasierte Wartung abhängig von einer Restlebensdauer nicht möglich. Die Folge sind häufig Funktionsausfälle bei derartigen mechatronischen Systemen, die zu ungeplanten Stillständen und somit hohen Ausfallkosten führen. US2014379199A1 offenbart ein auf einer Schädigungsvorhersage beruhendes Verfahren zur Erstellung einer Strategie zum Betrieb eines Kraftfahrzeugs anzugeben, welche bezüglich der Alterung wenigstens einer Komponente des Kraftfahrzeugs und der Betriebseffizienz des Kraftfahrzeugs, z.B. bzgl. des Energie- bzw. Kraftstoffverbrauchs, möglichst optimal ist.

US 2011/137575 A1 offenbart Echtzeit-Prognoseanalyse und nutzungsbasierte Restlebensdauerbewertung von Turbinentriebwerkskomponenten und deren Anzeige, und US 2012/283963 A1 offenbart ein Verfahren zur Vorhersage der Restnutzungsdauer eines Motors und seiner Komponenten. Sie offenbaren jedoch nicht , dass ein Betätigungsparameter einer Kompensationseinrichtung, welcher die Basis für eine spätere Betätigung bildet, zur Bestimmung eines Ausmaßes der Schädigung herangezogen wird.

Hier setzt die Erfindung an. Aufgabe der Erfindung ist es, ein Verfahren zur Bestimmung eines Ausmaßes einer Schädigung einer Komponente eines mechatronischen Systems anzugeben, mit welchem bei mechatronischen Systemen mit einer Kompensationseinrichtung, mit welcher Auswirkungen einer Schädigung der Komponente auf die Funktion des Systems bis zu einem Versagensschädigungsausmaß kompensiert werden können, wobei auch ein Ausmaß der Schädigung bestimmbar sein soll, welches geringer als das Versagensschädigungsausmaß ist.

Diese Aufgabe wird erfindungsgemäß durch ein Verfahren nach Anspruch 1 gelöst. Bevorzugte Ausführungen der Erfindung sind Gegenstände der abhängigen Ansprüche. Im Rahmen der Erfindung wurde erkannt, dass bei einem Verfahren zur Bestimmung eines Ausmaßes einer Schädigung einer Komponente eines mechatronischen Systems, welches System eine Kompensationseinrichtung zur Kompensation der Auswirkung der Schädigung der Komponente aufweist, sodass eine Ist-Funktion des mechatronischen Systems auch bei einem Ausmaß der Schädigung der Komponente aufrechterhalten werden kann, welches Ausmaß geringer als ein Versagensschädigungsausmaß ist, wobei die Kompensationseinrichtung zur Beeinflussung einer Betätigung der Komponente sowie zur Erfassung einer Ist-Funktion des Systems und zur Speicherung eines der Betätigung entsprechenden Betätigungsparameters eingerichtet ist, um bei einer Abweichung der Ist-Funktion von einer Soll-Funktion, welche Abweichung durch eine zunehmende Schädigung der Komponente bewirkt ist und eine vordefinierte Toleranz überschreitet, die Betätigung der Komponente in der Weise zu beeinflussen, dass die Ist-Funktion wieder der Soll-Funktion entspricht, und anschließend die geänderte Betätigung im Betätigungsparameter zu speichern, wobei dieser Betätigungsparameter die Basis für spätere Betätigungen bildet, das Ausmaß der Schädigung mittels des Betätigungsparameters bestimmt werden kann.

Dieser Betätigungsparameter liegt bei derartigen Systemen ohnedies vor, da bei jeder Änderung eines Ausmaßes der Betätigung, die zur Gewährleistung der Funktion des Systems erforderlich ist, der geänderte Betätigungsparameter abgespeichert wird, um für weitere Betätigungen eingesetzt werden zu können. Dieser Betätigungsparameter kann auf einfache Weise ausgelesen und zur Bestimmung der Schädigung der Komponente eingesetzt werden.

Günstig ist es, wenn ein zeitlicher Verlauf des Betätigungsparameters gespeichert wird und ein Ausmaß der Schädigung basierend auf einer zeitlichen Änderung des Betätigungsparameters bestimmt wird. So zeigt sich häufig ein geändertes Schädigungsverhalten mit zunehmender Schädigung, beispielsweise bei gleichbleibender Last eine gegen Ende einer Lebensdauer zunehmende Geschwindigkeit der Schädigung bzw. eine mit geringer werdendem Abstand von einem Versagensschädigungsausmaß zunehmende Geschwindigkeit der Schädigung. Durch Erfassung dieser Geschwindigkeit der Schädigungszunahme über den zeitlichen Verlauf des Betätigungsparameters kann somit auch auf ein tatsächlich vorliegendes Ausmaß der Schädigung geschlossen werden.

Weiter ist es günstig, wenn ein zeitlicher Verlauf einer Belastung der Komponente und ein zeitlicher Verlauf des Betätigungsparameters gespeichert werden, wobei das Ausmaß der Schädigung mittels einer Änderung des Betätigungsparameters innerhalb eines definierten Zeitraumes relativ zu einer kumulierten Belastung der Komponente innerhalb des definierten Zeitraumes bestimmt wird. Es konnte festgestellt werden, dass eine Zunahme der Schädigung abhängig von der bereits erfolgten Schädigung verschiedener Komponenten häufig nicht linear mit einer Belastung der Komponente steigt, sondern eine gleichbleibende Belastung häufig gegen Ende einer Lebensdauer zu einer stärkeren Schädigung in kürzerer Zeit führt bzw. eine Geschwindigkeit einer Schädigungszunahme mit geringer werdendem Abstand von einem Versagensschädigungsausmaß zunimmt, sodass über eine in Bezug auf die Belastung überproportional große Änderung des Betätigungsparameters auf ein unmittelbar bevorstehendes Ende der Lebensdauer der Komponente und somit einen Wartungsbedarf geschlossen werden kann. Nachdem die Last nicht zwingend gleichbleibend ist, kann nicht nur über eine Erfassung der zeitlichen Änderung des Betätigungsparameters, sondern auch über eine Erfassung des Betätigungsparameters in Abhängigkeit der bereits erfolgten Belastung bzw. in Abhängigkeit eines Lastkollektivs mit hoher Genauigkeit auf eine tatsächliche Schädigung der Komponente geschlossen werden.

Günstig ist es daher, wenn ergänzend zur Erfassung des Betätigungsparameters auch eine Belastung der Komponente erfasst wird, wobei bevorzugt sowohl der Betätigungsparameter als auch die Belastung der Komponente kontinuierlich aufgezeichnet werden.

Es kann auch vorgesehen sein, dass zunächst in Versuchen, über Aufzeichnungen bei entsprechenden Vorrichtungen oder rechnerisch ein Zusammenhang zwischen dem Betätigungsparameter und der Schädigung der Komponente ermittelt wird, sodass anhand eines aktuellen Betätigungsparameters unmittelbar auf eine Schädigung geschlossen werden kann.

Es ist somit bevorzugt vorgesehen, dass mittels eines Zusammenhangs zwischen Betätigungsparameter und Schädigung, welcher zuvor rechnerisch und/oder in Versuchen ermittelt wurde, eine Restlebensdauer des Systems bestimmt wird. Beispielsweise kann in einem Motor, welcher eine Kompensationseinrichtung zur Änderung einer Schließposition eines Ventils abhängig von einem Ventilverschleiß zur Aufrechterhaltung einer Funktion des Motors aufweist, regelmäßig der Betätigungsparameter der Kompensationseinrichtung, also eine geänderte Schließposition, ausgelesen und ein Verschleiß am Ventil bzw. am Ventilsitz gemessen werden, um einen direkten Zusammenhang zwischen dem Betätigungsparameter und dem tatsächlichen Verschleiß zu bestimmen, welcher Zusammenhang in weiteren Motoren genutzt werden kann, um über den Betätigungsparameter unmittelbar auf die Schädigung des Ventils schließen zu können.

Dadurch kann rechtzeitig vor Erreichen eines unzulässig hohen Verschleißes, also eines Versagensschädigungsausmaßes, bei welchem die Funktion des Motors nicht mehr gewährleistet werden kann, eine entsprechende Wartung geplant werden, um einen ungeplanten Stillstand zu vermeiden.

Günstig ist es bei einem Verfahren zum Warten eines mechatronischen Systems, dass ein Ausmaß einer Schädigung einer Komponente des Systems in einem erfindungsgemäßen Verfahren bestimmt wird, wobei eine Wartung durchgeführt wird, wenn die Schädigung ein vordefiniertes Wartungsausmaß überschreitet. Auf diese Weise können moderne mechatronische Systeme mit Kompensationseinrichtungen, die Auswirkungen von Schädigungen auf ein Systemverhalten bzw. eine Funktion des Systems kompensieren können, dennoch auf einfache Weise vorausschauend bzw. zustandsabhängig gewartet werden, und zwar ohne dass zusätzliche Sensoren erforderlich sind, zumal lediglich der Betätigungsparameter der Kompensationseinrichtung für die Planung der Instandhaltung bzw. Wartung eingesetzt wird.

Ein erfindungsgemäßes Verfahren zum Warten eines mechatronischen Systems kann grundsätzlich für jedes mechatronische System eingesetzt werden, welches eine entsprechende Kompensationseinrichtung aufweist. Bevorzugt wird ein derartiges Verfahren zur Wartung einer Windkraftanlage oder eines Fahrzeuges eingesetzt.

Mit einem erfindungsgemäßen Verfahren wird ein Zusammenhang zwischen einem Wartungsbedarf und einem Betätigungsparameter einer Kompensationseinrichtung eines modernen mechatronischen Systems hergestellt.

Über die Wartung des mechatronischen Systems hinaus kann der entsprechende Zusammenhang auch dazu genutzt werden, Belastungen der jeweiligen Komponente zu ermitteln, welche zu einer Schädigung bzw. Degradation führen bzw. einen Zusammenhang zwischen auftretenden Lasten und einer Schädigung der Komponente zu bestimmen, sodass schädigende Last- und/oder Randbedingungen einfach identifiziert werden können.

Somit können auch System-Antwort-Modelle auf einfache Weise kalibriert werden, indem über den Betätigungsparameter ein besonders genauer Indikator für eine Schädigung der Komponente vorliegt. Darüber hinaus ist es mit einem erfindungsgemäßen Verfahren auch möglich, basierend auf den ohnedies bei entsprechend modernen mechatronischen System an vorliegenden Daten eine Restlebensdauer zu bestimmen, um die Systeme besser ausnutzen zu können.

Weitere Merkmale, Vorteile und Wirkungen der Erfindung ergeben sich anhand des nachfolgend dargestellten Ausführungsbeispiels. In der Zeichnung, auf welche dabei Bezug genommen wird, zeigen:

> Fig. 1 ein Schema eines Verfahrens zur Bestimmung eines Ausmaßes einer Schädigung;
> Fig. 2 schematisch einen Zusammenhang zwischen einem Betätigungsparameter und einer Last;
> Fig. 3 schematisch einen Zusammenhang zwischen einem Betätigungsparameter und einer Schädigung.

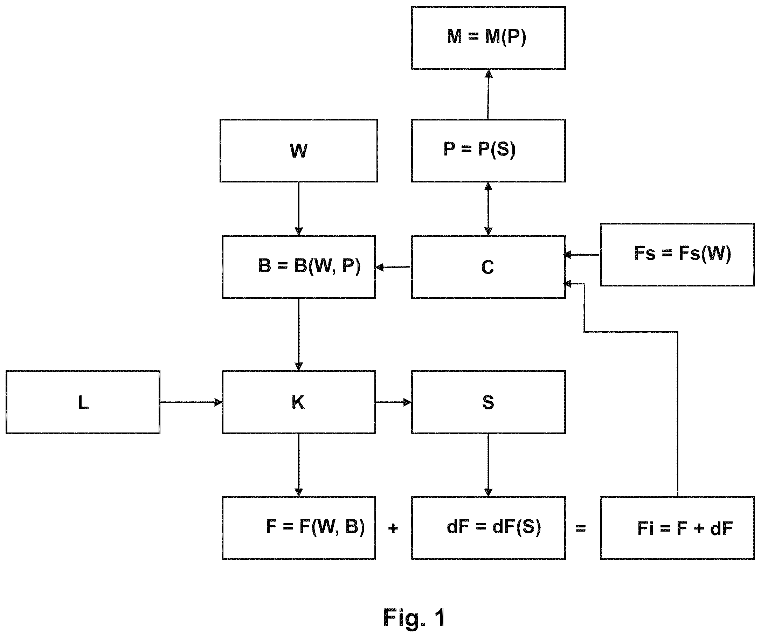

Fig. 1 zeigt schematisch ein Verfahren zur Bestimmung eines Ausmaßes einer Schädigung S bzw. zur Bestimmung einer Schädigung S einer Komponente K eines modernen mechatronischen Systems.

Das System weist eine Komponente K auf, welche zur Durchführung einer Soll-Funktion Fs im System vorgesehen ist. Zur Durchführung der Soll-Funktion Fs wird die Komponente K in einem Betrieb üblicherweise betätigt, wobei auf einen Wunsch W nach der Soll-Funktion Fs der Komponente K hin eine entsprechende Betätigung B ausgeübt wird. Die Soll-Funktion Fs ist somit abhängig von einem bestimmten Wunsch W nach einem bestimmten Verhalten des Systems, weswegen die Soll-Funktion Fs auch als

$$Fs = Fs(W)$$

ausgedrückt werden kann.

Der Wunsch W nach einer Betätigung B kann dabei automatisiert oder manuell ausgedrückt werden.

Beispielsweise können das System als Verbrennungsmotor und die Komponente K als Ventil ausgebildet sein. Auf einen durch die Motorsteuerung ausgedrückten Wunsch W nach einem vollständigen Schließen des Brennraumes hin wird das Ventil beispielsweise mit einer Nockenwelle oder einem anderen Aktuator betätigt. Die Soll-Funktion Fs, welche durch die Betätigung B erreicht werden soll, entspricht in diesem Beispiel somit einem geschlossenen Ventil ohne Leckage.

In der Regel entspricht eine Funktion F des Systems in einem Neuzustand der Soll-Funktion Fs.

Gleichzeitig wirkt auf die Komponente K bei einem Beitrieb eine Last L, welche zu einer Schädigung S der Komponente K führt. Die Schädigung S an der Komponente K führt wiederum zu einer Differenzfunktion dF, um welche die tatsächliche Ist-Funktion Fi des Systems von einer Funktion F der Komponente K ohne Schädigung S abweicht. Anders ausgedrückt wird eine Ist-Funktion Fi der Komponente K gebildet durch eine Summe aus einer Funktion F der Komponente K ohne Schädigung S bzw. einer Funktion F der Komponente K in einem Neuzustand und der Differenzfunktion dF, die sich insbesondere aus der Schädigung S ergibt.

Mathematisch kann die Ist-Funktion Fi daher als Summe aus einer Funktion F der Komponente K und der durch die Schädigung S bedingten Differenzfunktion dF wie folgt ausgedrückt werden:

$$Fi = F + dF$$

Es versteht sich, dass die schadensbedingte Differenzfunktion dF auch abhängig von einer Betätigung B sein kann, sodass sich eine Schädigung S bei unterschiedlich starken Betätigungen B unterschiedlich stark auf die Funktion F auswirkt.

Im vorstehend angeführten Beispiel wird die Last L am Ventil insbesondere gebildet durch eine Schließbewegung bzw. einen harten Kontakt des Ventils mit einem Ventilsitz, welcher zu einem Verschleiß am Ventil sowie am Ventilsitz führt. Der Verschleiß bildet somit hier die Schädigung S der Komponente K, wobei eine Differenzfunktion dF durch einen Abstand zwischen dem Ventil und dem Ventilsitz in einer Position gebildet sein kann, in welcher Position das Ventil in einem Neuzustand dichtend am Ventilsitz sitzt. Diese Differenzfunktion dF führt somit ohne weitere Korrektur zu einer Leckage des Ventils, sodass die Ist-Funktion Fi von der Soll-Funktion Fs abweicht.

Um diese Leckage auch bei einem Verschleiß zu verhindern, weisen moderne Verbrennungsmotoren Kompensationseinrichtungen C auf, welche beispielsweise eine durch den Verschleiß bedingte Leckage erfassen können und mit welchen eine Position des Ventils in einem geschlossenen Zustand derart änderbar ist, dass eine Leckage trotz des Verschleißes vermieden ist. Dies kann zu einer Nullpunktverschiebung eines Verfahrweges des Ventils und/oder einem größeren Hub des Ventils führen.

Die Kompensationseinrichtung C wirkt somit auf eine Betätigung B des Ventils, sodass die Betätigung B bei gleichem Wunsch W nach einer Soll-Funktion Fs mit zunehmendem Verschleiß geändert wird. Die Kompensationseinrichtung C ist also zum Vergleich der Ist-Funktion Fi mit der Soll-Funktion Fs ausgebildet und dazu eingerichtet, die Betätigung B in der Weise zu beeinflussen, dass die Soll-Funktion Fs der Komponente K trotz der Schädigung S erreicht wird, solange ein Ausmaß der Schädigung S geringer als ein Versagensschädigungsausmaß V ist.

Weiter ist die Kompensationseinrichtung C dazu ausgebildet, einen der geänderten Betätigung B entsprechenden Betätigungsparameter P zu speichern, sodass eine zukünftige Betätigung B der Komponente K basierend auf dem zuletzt gespeicherten Betätigungsparameter P erfolgen kann. Eine Änderung des Betätigungsparameters P, welche eine Änderung der Betätigung B bei gleichem Wunsch W nach einer Soll-Funktion Fs zur Folge hat, erfolgt somit üblicherweise nur dann, wenn eine Abweichung der Ist-Funktion Fi von der Soll-Funktion Fs bestimmt wird.

Die tatsächliche Betätigung B der Komponente K ist somit bei einem derartigen System nicht nur von einem Wunsch W nach einer bestimmten Soll-Funktion Fs abhängig, sondern auch von einer bereits vorhandenen Schädigung S bzw. einer dadurch bedingten Differenzfunktion dF, welche durch eine geänderte Betätigung B ausgeglichen werden muss, um die Soll-Funktion Fs zu erreichen.

Die Änderung der Betätigung B durch die erfolgte Schädigung S wird wiederum im Betätigungsparameter P abgebildet, weswegen die Betätigung B auch als Funktion F des Wunsches W nach einer bestimmten Soll-Funktion Fs und der im Betätigungsparameter P gegebenenfalls enthaltenen Korrektur der Betätigung B zum Ausgleich der Schädigung S bzw. als Funktion

$$B = B(W, P)$$

ausgedrückt werden kann, wonach die Betätigung B sowohl vom Wunsch W, in welchem die Soll-Funktion Fs enthalten ist, als auch vom Betätigungsparameter P abhängig ist.

Im genannten Beispiel kann somit eine Abweichung der Soll-Funktion Fs von der Ist-Funktion Fi beispielsweise durch eine Leckage, einen schlechteren Wirkungsgrad bzw. einen erhöhten Kraftstoffverbrauch oder dergleichen bestimmt werden, um in der Kompensationseinrichtung C eine Änderung des Betätigungsparameters P auszulösen, welche zu einer geänderten Betätigung B führt. Die geänderte Betätigung B kann beispielsweise zu einer Nullpunktverschiebung des Ventils führen, sodass diese Nullpunktverschiebung als Teil der durch die Betätigung B bedingten Funktion F in Verbindung mit der durch die Schädigung S bedingten Differenzfunktion dF wieder zu einer der Soll-Funktion Fs entsprechenden Ist-Funktion Fi führt. Durch die von der Kompensationseinrichtung C ausgelöste Nullpunktverschiebung wird somit der Verschleiß ausgeglichen.

Mit der Kompensationseinrichtung C kann somit eine der Soll-Funktion Fs entsprechende Ist-Funktion Fi des Systems auch bei einer Schädigung S der Komponente K aufrechterhalten werden, solange das Ausmaß dieser Schädigung S geringer als ein Versagensschädigungsausmaß V ist. Das Versagensschädigungsausmaß V kann beispielsweise durch einen Bruch des Ventils gebildet sein.

Nachteilig dabei ist allerdings, dass durch die Aufrechterhaltung der Soll-Funktion Fs über eine Überwachung der Funktion F nicht mehr auf ein Ausmaß einer Schädigung S der Komponente K geschlossen werden kann. Es ist daher bei derartigen Systemen nicht mehr möglich, basierend auf der Ist-Funktion Fi des Systems einen Austausch der Komponente K im Rahmen einer geplanten Wartung M derart zu planen, dass die Komponente K weder zu früh getauscht wird noch ein ungeplanter Stillstand durch ein Versagen der Komponente K riskiert wird.

Um eine Schädigung S der Komponente K dennoch bestimmen zu können, ist nun vorgesehen, dass der Betätigungsparameter P zur Beurteilung der Schädigung S herangezogen wird.

Dieser Betätigungsparameter P liegt im System ohnedies vor, sodass hierzu auch kein weiterer Sensor erforderlich ist, um auf die Schädigung S zu schließen, zumal der Zusammenhang

$$P = P(S)$$

gegeben ist.

Wie in Fig. 1 ersichtlich kann der Betätigungsparameter P neben der Beurteilung der Schädigung S auch direkt zur Planung von Wartungsmaßnahmen eingesetzt werden. Die Wartungsmaßnahmen werden somit abhängig vom Betätigungsparameter P gewählt und terminisiert, sodass die Wartung M zustandsbasiert abhängig von der Schädigung S erfolgen kann, welche jedoch nur mittelbar über den Betätigungsparameter P bestimmt wird. Anders ausgedrückt ist somit

$$M = M(P)$$

So wurde im Rahmen der Erfindung erkannt, dass ein Zusammenhang zwischen dem Betätigungsparameter P und der Schädigung S besteht, welcher Zusammenhang für eine Bestimmung der Schädigung S basierend auf dem Betätigungsparameter P genutzt werden kann.

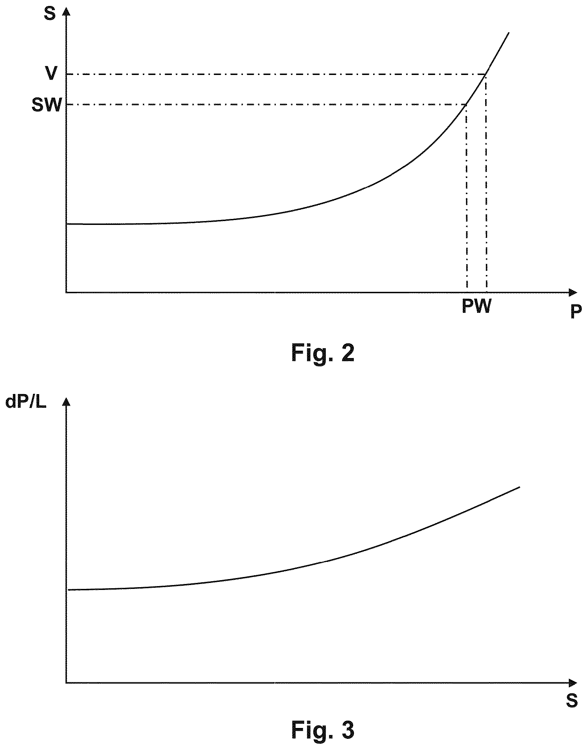

Fig. 2 zeigt schematisch einen solchen Zusammenhang zwischen dem Betätigungsparameter P und der Schädigung S. Ein derartiger Zusammenhang kann linear sein, muss dies jedoch wie der in Fig. 2 dargestellte nicht sein. Beispielsweise kann die Schädigung S stärker oder weniger stark als der Betätigungsparameter P steigen. Über die Bestimmung eines derartigen Zusammenhangs, beispielsweise in Rechnungen, Versuchen oder Erprobungen, kann eine Schädigung S der Komponente K direkt über den Betätigungsparameter P ermittelt werden.

Somit kann einerseits ein Wert des Betätigungsparameters P bestimmt werden, bei dem eine Funktion F des Systems nicht mehr gewährleistet werden kann. Dieser Wert entspricht somit einem Versagensschädigungsausmaß V der Komponente K. Weiter kann ein Wartungswert PW des Betätigungsparameters P definiert werden, wobei ein Erreichen dieses Wartungswertes PW eine Wartung M auslösen kann, welche einen Austausch der Komponente K umfassen kann. Dieser Wartungswert PW ist wie in Fig. 2 ersichtlich geringer als der Wert des Betätigungsparameters P in einem Schadensfall, in welchem die Schädigung S ein Versagensschädigungsausmaß V erreicht. Mit diesem Wartungswert PW korrespondiert somit ein Wartungsausmaß SW der Schädigung S der Komponente K, welches geringer ist als das Versagensschädigungsausmaß V, sodass bei Einleitung einer Wartung M bei Erreichen dieses Wartungsausmaßes SW noch ausreichend Zeit für den Austausch verbleibt und ein ungeplanter Stillstand vermieden werden kann.

Fig. 3 zeigt einen Zusammenhang zwischen einem Verhältnis von einer Änderung des Betätigungsparameters P zu einer Änderung des Lastkollektives über eine Schädigung S der Komponente K. Wie ersichtlich kann auch hier eine Nichtlinearität vorliegen bzw. ein entsprechender Zusammenhang dergestalt sein, dass die Komponente K bei gleichbleibender Last L abhängig von einem Schädigungszustand eine stärkere Änderung des Betätigungsparameters P erfordert, um eine Funktion F aufrechterhalten zu können. Über einen entsprechenden Zusammenhang kann auf einfache Weise durch kontinuierliche Messung des Betätigungsparameters P einerseits und der Last L andererseits auf eine tatsächliche Schädigung S und gegebenenfalls eine Restlebensdauer geschlossen werden, selbst wenn noch kein direkter Zusammenhang zwischen dem Betätigungsparameter P und dem Schadensausmaß bestimmt werden konnte. Eine ergänzende Messung der Last L bzw. eine Aufzeichnung eines Lastkollektivs und Vergleich desselben mit dem Verlauf des Betätigungsparameters P kann somit ebenfalls zur Planung von Wartungsmaßnahmen eingesetzt werden.

Darüber hinaus kann auf diese Weise einfach ein Zusammenhang unterschiedlicher Belastungen auf eine Schädigung S der Komponente K ermittelt werden, um diesen Zusammenhang wiederum für eine Restlebensdauerabschätzung nutzen zu können.

Auf Basis der mittels des Betätigungsparameters P ermittelten Schädigung S kann auf einfache Weise eine Wartung M bzw. ein Austauschen der Komponente K geplant werden, wenn absehbar ist, dass ein Ende der Lebensdauer bald erreicht ist bzw. ein Versagensschädigungsausmaß V erreicht wird.

Das erfindungsgemäße Verfahren kann für verschiedenste mechatronische Systeme eingesetzt werden.

Beispielhaft wird hier die Anwendung des Verfahrens für unterschiedliche mechatronische Systeme wie folgt angegeben:

- Der Verschleiß an einem Ventilsitz eines Verbrennungsmotors würde ohne entsprechende Kompensation zu einer Leckage am Ventil führen. Durch eine entsprechende Kompensationseinrichtung C wird eine Geschlossen-Position des Ventils verändert, sodass ein Verfahrweg des Ventils steigt. Eine Änderung des Verfahrweges bildet somit in diesem Beispiel den Betätigungsparameter P, der aus der Kompensationseinrichtung C auf einfache Weise ausgelesen werden kann, um auf einen Verschleiß des Ventils schließen und rechtzeitig einen Austausch planen zu können.

- Eine Alterung einer Ventilauflagefläche bei einem Ventil eines Verbrennungskraftmotors führt ebenfalls zu einer Leckage, welche wiederum durch eine Änderung einer Geschlossen-Position des Ventils und somit eine Erhöhung des Verfahrweges des Ventils kompensiert werden kann. Auch die hier die Schädigung S bildende Alterung der Ventilauflagefläche kann somit mittels des in diesem Beispiel den Betätigungsparameter P bildenden Verfahr-Weges ermittelt werden.

- Die Anwendung des Verfahrens ist jedoch nicht auf mechanische Systeme beschränkt. So kann beispielsweise ein elektrisches Kontaktproblem, welches durch Korrosion oder Oxidation bedingt sein kann, zu einem erhöhten Kontaktwiderstand führen. Um diesen zusätzlichen, hier die Schädigung S bildenden Widerstand zu kompensieren, kann eine Input-Leistung gesteigert werden, um die zusätzliche Verlustleistung am Kontakt auszugleichen. Über die hier den Betätigungsparameter P bildende Zusatzleistung kann auf eine Schädigung S des Kontaktes geschlossen werden.

- Bei einer Alterung einer Generator-Wicklung kann eine geänderte Leitfähigkeit der Wicklung durch eine entsprechend geänderte Erreger-Spannung ausgeglichen werden. Die in diesem Beispiel die Schädigung S bildende geänderte Leitfähigkeit wird somit durch den hier den Betätigungsparameter P bildenden Wert einer geänderten Spannung ausgeglichen, um eine gewünschte Funktion F, hier eine magnetische Durchflutung, zu erreichen. Die Änderung der Spannung kann aus der Kompensationseinrichtung C auch hier einfach ausgelesen und zur Bestimmung der Schädigung S genutzt werden.

- Bei einem Wärmetauscher kann eine Verschmutzung als Schädigung S angesehen werden, welche eine Funktion F des Wärmetauschers beeinträchtigt. Um diese Funktionsbeeinträchtigung auszugleichen, kann eine Einschalt-Temperatur eines auf den Wärmetauscher wirkenden Ventilators reduziert werden, sodass der Ventilator bereits bei geringerer Temperatur des Wärmetauschers aktiviert wird, um einen Wärmeübergang zu erhöhen und somit die Funktion F auch bei einer Verschmutzung aufrechterhalten zu können. In diesem Beispiel bildet somit die Änderung der Einschalttemperatur den Betätigungsparameter P, mit welchem die Schädigung S bestimmt werden kann.

Es versteht sich, dass die Anwendung des Verfahrens nicht auf die genannten Beispiele beschränkt ist, sondern zur Bestimmung verschiedenster Arten von Schädigungen S bei unterschiedlichsten mechatronischen Komponenten K genutzt werden kann.

Mit einem erfindungsgemäßen Verfahren ist es auf einfache Weise, insbesondere ohne dem Erfordernis, einen weiteren Sensor vorzusehen, möglich, eine Schädigung S auch bei modernen mechatronischen Systemen zu bestimmen, welche eine Kompensationseinrichtung C zum Ausgleich der Auswirkungen von Schädigungen S aufweisen, wobei konventionelle Verfahren nicht mehr einsetzbar sind. Basierend auf den im erfindungsgemäßen Verfahren ermittelten Ausmaß der Schädigung S kann anschließend eine zustandsbasierte Wartung M rechtzeitig vor einem ungeplanten Stillstand durchgeführt werden.

## Patentansprüche

1. Verfahren zur Bestimmung eines Ausmaßes einer Schädigung (S) einer Komponente (K) eines mechatronischen Systems, welches System eine Kompensationseinrichtung (C) zur Kompensation der Auswirkung der Schädigung (S) der Komponente (K) aufweist, sodass eine Ist-Funktion (F) des mechatronischen Systems auch bei einem Ausmaß der Schädigung (S) der Komponente (K) aufrechterhalten werden kann, welches geringer als ein Versagensschädigungsausmaß (V) ist, wobei die Kompensationseinrichtung (C) zur Beeinflussung einer Betätigung (B) der Komponente (K) sowie zur Erfassung einer Ist-Funktion (Fi) des Systems und zur Speicherung eines der Betätigung (B) entsprechenden Betätigungsparameters (P) eingerichtet ist, um bei einer Abweichung der Ist-Funktion (Fi) von einer Soll-Funktion (Fs), welche Abweichung durch eine zunehmende Schädigung (S) der Komponente (K) bewirkt ist und eine vordefinierte Toleranz überschreitet, die Betätigung (B) der Komponente (K) in der Weise zu beeinflussen, dass die Ist-Funktion (Fi) wieder der Soll-Funktion (Fs) entspricht, und anschließend die geänderte Betätigung (B) im Betätigungsparameter (P) zu speichern, wobei dieser Betätigungsparameter (P) die Basis für spätere Betätigungen (B) bildet, wobei das Ausmaß der Schädigung (S) mittels des Betätigungsparameters (P) bestimmt wird.

2. Verfahren nach Anspruch 1, **dadurch gekennzeichnet, dass** ein zeitlicher Verlauf des Betätigungsparameters (P) gespeichert wird und ein Ausmaß der Schädigung (S) basierend auf einer zeitlichen Änderung des Betätigungsparameters (P) bestimmt wird.

3. Verfahren nach Anspruch 1 oder 2, **dadurch ge-**

**kennzeichnet, dass** ein zeitlicher Verlauf einer Belastung der Komponente (K) und ein zeitlicher Verlauf des Betätigungsparameters (P) gespeichert werden, wobei das Ausmaß der Schädigung (S) mittels einer Änderung des Betätigungsparameters (P) innerhalb eines definierten Zeitraumes relativ zu einer kumulierten Belastung der Komponente (K) innerhalb des definierten Zeitraumes bestimmt wird.

4. Verfahren nach einem der Ansprüche 1 bis 3, **dadurch gekennzeichnet, dass** mittels eines Zusammenhanges zwischen Betätigungsparameter (P) und Schädigung (S), welcher zuvor rechnerisch und/oder in Versuchen ermittelt wurde, die Schädigung (S) anhand des Betätigungsparameters (P) bestimmt wird.

5. Verfahren nach einem der Ansprüche 1 bis 4, **dadurch gekennzeichnet, dass** mittels eines Zusammenhanges zwischen Betätigungsparameter (P) und Schädigung (S), welcher zuvor rechnerisch und/oder in Versuchen ermittelt wurde, eine Restlebensdauer des Systems bestimmt wird.

6. Verfahren zum Warten eines mechatronischen Systems, wobei ein Ausmaß einer Schädigung (S) einer Komponente (K) des Systems in einem Verfahren nach einem der Ansprüche 1 bis 5 bestimmt wird, wobei eine Wartung (M) durchgeführt wird, wenn die Schädigung (S) ein vordefiniertes Wartungsausmaß (SW) überschreitet.

7. Verfahren nach einem der Ansprüche 1 bis 6, **dadurch gekennzeichnet, dass** das Verfahren zur Wartung (M) einer Windkraftanlage oder eines Fahrzeuges eingesetzt wird.

## Claims

1. A method for determining a degree of damage (S) to a component (K) of a mechatronic system, which system comprises a compensation device (C) for compensating for the effect of the damage (S) to the component (K), so that an actual function (F) of the mechatronic system can be maintained even when the degree of damage (S) to the component (K) is less than a failure damage level (V), wherein the compensation device (C) is configured to influence an actuation (B) of the component (K) and to detect an actual function (Fi) of the system and to store an actuation parameter (P) corresponding to the actuation (B), in order to influence the actuation (B) of the component (K) in such a manner that, in the event of a deviation of the actual function (Fi) from a target function (Fs), which deviation is caused by increasing damage (S) to the component (K) and exceeds a predefined tolerance, the actual function (Fi) again corresponds to the target function (Fs), and subsequently to store the modified actuation (B) in the actuation parameter (P), wherein this actuation parameter (P) forms the basis for subsequent actuations (B), wherein the degree of damage (S) is determined by means of the actuation parameter (P).

2. The method according to claim 1, **characterized in that** a time profile of the actuation parameter (P) is stored and a degree of damage (S) is determined based on a temporal change in the actuation parameter (P).

3. The method according to claim 1 or 2, **characterized in that** a time profile of a load on the component (K) and a time profile of the actuation parameter (P) are stored, wherein the degree of damage (S) is determined by means of a change in the actuation parameter (P) within a defined time period relative to a cumulative load on the component (K) within the defined time period.

4. The method according to any one of claims 1 to 3, **characterized in that** the damage (S) is determined on the basis of the actuation parameter (P) by means of a correlation between the actuation parameter (P) and the damage (S), which correlation was previously determined computationally and/or experimentally.

5. The method according to any one of claims 1 to 4, **characterized in that** a residual service life of the system is determined by means of a correlation between the actuation parameter (P) and the damage (S), which correlation was previously determined computationally and/or experimentally.

6. A method for maintaining a mechatronic system, wherein a degree of damage (S) to a component (K) of the system is determined using a method according to any one of claims 1 to 5, wherein maintenance (M) is carried out when the damage (S) exceeds a predefined maintenance threshold (SW).

7. The method according to any one of claims 1 to 6, **characterized in that** the method is used for maintaining (M) a wind turbine or a vehicle.

**Revendications**

1. Procédé de détermination d'une étendue d'un endommagement (S) d'un composant (K) d'un système mécatronique, lequel système comporte un dispositif de compensation (C) pour compenser la conséquence de l'endommagement (S) du composant (K), de telle manière qu'une fonction réelle (F) du système mécatronique peut être maintenue même à une étendue de l'endommagement (S) du composant (K), qui est plus faible qu'une étendue d'endommagement de défaillance (V), sachant que le dispositif de compensation (C) est agencé pour influencer un actionnement (B) du composant ainsi que pour la saisie d'une fonction réelle (Fi) du système et pour la mémorisation d'un paramètre d'actionnement (P) correspondant à l'actionnement (B) pour influencer l'actionnement (B) du composant (K) lors d'un écart de la fonction réelle (Fi) d'une fonction théorique (Fs), lequel écart est causé par un endommagement croissant (S) du composant (K) et dépasse une tolérance prédéfinie, de telle manière que la fonction réelle (Fi) correspond à nouveau à la fonction théorique (Fs) et pour mémoriser ensuite l'actionnement modifié (B) dans le paramètre d'actionnement (P), sachant que ce paramètre d'actionnement (P) forme la base pour des actionnements ultérieurs (B), sachant que l'étendue de l'endommagement (S) est déterminée au moyen du paramètre d'actionnement (P).

2. Procédé selon la revendication 1, **caractérisé en ce qu'**un profil temporel du paramètre d'actionnement (P) est mémorisé et une étendue de l'endommagement (S) est déterminée en se basant sur une variation temporelle du paramètre d'actionnement (P).

3. Procédé selon la revendication 1 ou 2, **caractérisé en ce qu'**un profil temporel d'une sollicitation du composant (K) et un profil temporel du paramètre d'actionnement (P) sont mémorisés, sachant que l'étendue de l'endommagement (S) est déterminée à l'intérieur d'une période de temps définie au moyen d'une modification du paramètre d'actionnement (P) par rapport à une sollicitation cumulée du composant (K).

4. Procédé selon l'une quelconque des revendications 1 à 3, **caractérisé en ce que** l'endommagement (S) est déterminé à l'aide du paramètre d'endommagement (P) au moyen d'un rapport existant entre le paramètre d'actionnement (P) et l'endommagement (S), lequel a été préalablement déterminé par calcul et/ou par des essais.

5. Procédé selon l'une quelconque des revendications 1 à 4, **caractérisé en ce qu'**une durée de vie résiduelle du système est déterminée au moyen d'un rapport existant entre le paramètre d'actionnement (P) et l'endommagement (S), lequel a été préalablement déterminé par calcul et/ou par des essais.

6. Procédé d'entretien d'un système mécatronique, sachant qu'une étendue d'un endommagement (S) d'un composant (K) du système est déterminée dans un procédé selon l'une quelconque des revendications 1 à 5, sachant qu'un entretien (M) est exécuté, lorsque l'endommagement (S) dépasse une étendue d'entretien (SW) prédéfinie.

7. Procédé selon l'une quelconque des revendications 1 à 6, **caractérisé en ce que** le procédé pour l'entretien (M) d'une installation éolienne ou d'un véhicule est mis en œuvre.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2014379199 A1
- US 2011137575 A1
- US 2012283963 A1